# EUROPÄISCHE PATENTSCHRIFT

(11) **EP 3 035 665 B1**
(45) Veröffentlichungstag und Bekanntmachung des Hinweises auf die Patenterteilung: **03.04.2019**
(21) Anmeldenummer: 15198391.3
(22) Anmeldetag: 08.12.2015
(51) Int. Cl.: H04N 5/225, G03B 17/02

(54) **KAMERASYSTEM MIT MODULARER LEITERPLATTENANORDNUNG**
CAMERA SYSTEM HAVING A MODULAR PRINTED CIRCUIT BOARD ARRANGEMENT
SYSTEME DE CAMERA COMPRENANT UN SYSTEME DE CARTES DE CIRCUIT IMPRIME

(30) Priorität: 18.12.2014 DE 102014019007
(43) Veröffentlichungstag der Anmeldung: 22.06.2016
(73) Patentinhaber: MEKRA LANG GmbH & Co. KG, 91465 Ergersheim (DE)
(72) Erfinder: GEIßENDÖRFER, Peter, 91605 Gallmersgarten (DE); LANG, Dr., Werner, 91465 Ergersheim (DE); DEFFNER, Simon, 91604 Flachslanden (DE); STÜRZENHOFECKER, Jens, 91459 Markt Erlbach (DE)
(74) Vertreter: Kramer Barske Schmidtchen Patentanwälte PartG mbB

(56) Entgegenhaltungen:
- WO-A1-93/03575
- DE-A1-102011 084 200
- DE-U1- 9 400 442
- US-A1- 2005 099 769
- US-A1- 2010 165 188

## Beschreibung

Die Erfindung betrifft ein Kamerasystem mit einer modularen Leiterplattenanordnung, beispielsweise für den Einsatz in Fahrzeugen, wie beispielsweise Nutzfahrzeugen.

Herkömmliche Kamerasysteme weisen üblicherweise gestapelte Leiterplatten mit vorgegebenen Platinenlayouts auf. Um Grundfunktionen einer Kamera, wie beispielsweise Bildaufnahme, Bildverarbeitung, Signalübertragung und elektrische Anschlüsse sowie eventuelle Zusatzfunktionen zu ändern, ist es bei herkömmlichen Kamerasystemen notwendig, das komplette Platinenlayout zu ändern, um individuelle benötigte Funktionen auszutauschen bzw. zu ergänzen oder wegzulassen. Ein derartiges Ändern des kompletten Platinenlayouts ist aufwendig und kostenintensiv.

WO 00/46984 A1 betrifft die Konstruktions- und Montageart einer intelligenten Kamera, inklusive Aufbau der Elektronik.

WO 2007/036308 A1 betrifft ein elektronisches Bildaufnahmesystem mit getrennten Modulen, insbesondere mit der Möglichkeit eine Mehrzahl von Schnittstellenmodulen auswählbar flexibel mittels eines gemeinsamen Bussystems austauschbar zu gestalten.

DE 199 63 836 A1 betrifft eine elektronische Kamera mit wenigstens einem lichtempfindlichen Sensorchip, der auf einer ersten Platine angeordnet ist und mit wenigstens einer Steuer-und Auswerteschaltung zum Ansteuern des Sensorchips.

US 2005/0099521 A1 betrifft eine Kamera zur optischen Bildbegebung in Weitwinkelbereich.

WO 93/03575 A1 offenbart eine CCD Kamera, die elektronisch erweiterbar ist, um an ein breites Spektrum von Verwendungsmöglichkeiten anpassbar zu sein.

Aufgabe der Erfindung ist es ein Kamerasystem bereitzustellen, mit dem es möglich ist, neue Kameravarianten mit individuell angepasstem Funktionsumfang der Kamera schnell und kostengünstig an Kundenanforderungen anzupassen.

Die Lösung der obigen Aufgabe erfolgt durch ein Kamerasystem gemäß den Merkmalen des Anspruchs 1. Vorteilhafte Weiterentwicklungen der Erfindung sind in den Unteransprüchen angegeben.

Das Kamerasystem gemäß der Erfindung basiert auf einem Baukastensystem mit Bauteilen einer definierten Teilefamilie für eine Kamera.

Das erfindungsgemäße Kamerasystem weist ein Objektiv auf, über das Bildinformation an einen auf einer ersten Leiterplatte angeordneten Bildsensor geliefert wird. Die erste Leiterplatte hat somit die Grundfunktion zum Erfassen von Bilddaten, die über das Objektiv erhalten werden. Ferner weist das erfindungsgemäße Kamerasystem mindestens eine weitere Leiterplatte auf, die für das Kamerasystem eine vorbestimmte weitere Funktion bereitstellt, wie beispielsweise eine Bildverarbeitung, Signalwandlung, Funkübertragung, Stromversorgung, Bildübertragung, Signalübertragung, Heizungssteuerung, Messwertübergabe, Audioaufnahme, etc.

Die obige erste Leiterplatte und jede der mindestens einen weiteren Leiterplatte mit mindestens einer Verbindungseinheit versehen, über die die Leiterplatten jeweils elektrisch miteinander modular austauschbar verbindbar sind zur Anpassung des Funktionsumfangs des Kamerasystems.

Durch das Vorsehen einer derartigen modularen Leiterplattenanordnung ist es möglich, neue Kameravarianten mit weniger Entwicklungsaufwand/-kosten bereitzustellen, und den Funktionsumfang des Kamerasystems individuell an Kundenanforderungen anzupassen. Speziell ist es möglich, benötigte bzw. nicht benötigte Funktionen/Leiterplatten in das Kamerasystem einzubauen bzw. wegzulassen, je nach Kundenanforderung.

Durch die Verwendung einer standardisierten Teilefamilie für das Kamerasystem ist es ferner möglich eine Risikominimierung für Fehlfunktionen sowie eine Kostenreduzierung bei der Herstellung des Kamerasystems zu erhalten.

Vorzugsweise sind bei dem erfindungsgemäßen Kamerasystem die jeweiligen Verbindungseinheiten der Leiterplatten an zu einander geometrisch kompatiblen vorbestimmten Positionen auf mindestens einer Oberflächenseite der Leiterplatte angeordnet. Die Anordnung der jeweiligen Verbindungseinheiten kann beispielsweise auf einer Oberflächenseite der Leiterplatte vorgesehen sein oder alternativ auf zwei gegenüberliegenden Oberflächenseiten der Leiterplatte, also auf einer Vorderseite und einer Rückseite der Leiterplatte.

Das Kamerasystem gemäß der Erfindung weist vorzugsweise mindestens eine Verbindungseinheit für eine Leiterplatte auf, die eine Mehrzahl von Gruppen von elektrischen Anschlüssen aufweist, über die die Leiterplatte zur Bereitstellung einer vorbestimmten Grundfunktion für das Kamerasystem mit anderen Leiterplatten verbindbar ist.

Speziell ist vorzugsweise die erste Leiterplatte, die als eine Sensorplatine ausgebildet ist, auf der der Bildsensor angeordnet ist, über eine Gruppe von elektrischen Anschlüssen der Verbindungseinheit der ersten Leiterplatte mit einer weiteren Leiterplatte, die beispielsweise eine Bildverarbeitungsfunktion für das Kamerasystem bereitstellt, verbindbar. Ebenso ist vorzugsweise die weitere Leiterplatte, die die Bildverarbeitungsfunktion für das Kamerasystem bereitstellt, über eine Gruppe von elektrischen Anschlüssen der Verbindungseinheit der weiteren Leiterplatte mit einer noch weiteren Leiterplatte, die beispielsweise eine Stromlieferfunktion für das Kamerasystem bereitstellt, verbindbar.

Zur Gewährleistung einer schnellen und zuverlässigen Erweiterung des Funktionsumfangs des Kamerasystems sind die elektrischen Anschlüsse einer jeweiligen Gruppe von elektrischen Anschlüssen an vordefinierten Stellen positioniert.

Bei dem Kamerasystem gemäß der Erfindung ist vorzugsweise eine Mehrzahl von Gruppen von elektrischen Anschlüssen nebeneinander in einer Reihe angeordnet, speziell sind mehrere Verbindungseinheiten, die jeweils die Mehrzahl von Gruppen von elektrischen Anschlüssen aufweisen, pro Leiterplatte vorgesehen. Diese Verbindungseinheiten sind beispielsweise auf einer Oberflächenseite einer Leiterplatte angeordnet, oder alternativ auf einer Vorderseite und einer Rückseite derart, dass sie sich geometrisch gegenüberliegen.

Bei dem Kamerasystem gemäß der Erfindung sind vorzugsweise mehrere Leiterplatten hintereinander derart angeordnet, dass die erste Leiterplatte bei dem Objektiv des Kamerasystems angeordnet ist und auf einer Seite der ersten Leiterplatte, die dem Objektiv abgewandt ist, die weiteren Leiterplatten zur Bereitstellung entsprechender Funktionen des Kamerasystems hintereinander angeordnet sind. Vorzugsweise weist die Letzte in dieser Anordnung vorgesehene Leiterplatte einen elektrischen Anschluss auf, mit dem beispielsweise ein Videosignal, Audiosignal und/oder Steuerungssignal nach außen übertragen werden kann, bzw. über diesen elektrischen Anschluss in das Kamerasystem eingespeist werden kann. Ein derartiger elektrischer Anschluss kann auch auf einer oder mehreren der anderen Leiterplatten vorgesehen werden.

Gemäß der Erfindung befinden sich auf den jeweiligen Leiterplatten entsprechende elektronische Bausteine bzw. Bauteile, die angepasst sind zur Bereitstellung der vorbestimmten Grundfunktionen zur Anpassung des Kamerasystems. Derartige vorbestimmte Grundfunktionen zur Anpassung des Kamerasystems sind gemäß der Erfindung beispielsweise Videoverarbeitung, Videoübertragung, Signalumwandlung, Funkübertragung, Stromversorgung, Signalübertragung, Heizungssteuerung, Messwertübergabe, Audioaufnahme, etc.

Für den schnellen und zuverlässigen Aufbau des Kamerasystems gemäß der Erfindung sind die jeweiligen Verbindungseinheiten der Leiterplatten beispielsweise als Steckverbindungen ausgebildet zur elektrischen Verbindung der Leiterplatten miteinander über die elektrischen Anschlüsse der jeweiligen Gruppen von elektrischen Anschlüssen. Andere Verbindungstechniken, wie beispielsweise Kabel, Verlöten, Funk, etc. können verwendet werden.

Das erfindungsgemäße Kamerasystem kann beispielsweise in Spiegelersatzsystemen für Fahrzeuge, insbesondere Nutzfahrzeuge verwendet werden, um kontinuierlich und dauerhaft Bildinformation von der Umgebung des Fahrzeugs in Echtzeit auf einer Anzeigevorrichtung im Fahrzeuginneren und/oder außerhalb des Fahrzeugs bereitzustellen.

Bevorzugte Ausführungsbeispiele der Erfindung werden nachfolgend unter Bezugnahme auf die beigefügten Zeichnungen beschrieben, wobei gleiche Bauteile mit gleichen Bezugszeichen versehen sind. Es zeigen:
Fig. 1 eine schematische Querschnittsansicht eines Kamerasystems gemäß einem Beispiel zur Erklärung der Erfindung.
Fig. 2 eine schematische Querschnittsansicht eines Kamerasystems gemäß einem Ausführungsbeispiels der Erfindung;
Fig. 3 eine schematische Draufsicht auf eine Leiterplatte gemäß der Erfindung; und
Fig. 4 eine schematische Ansicht einer Verbindungseinheit gemäß der Erfindung.

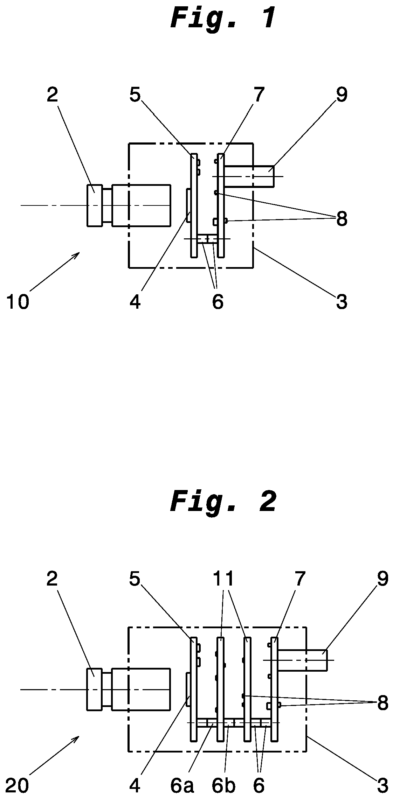

Fig. 1 zeigt eine schematische Querschnittsansicht eines Kamerasystems 10 gemäß einem Beispiel zur Erklärung der Erfindung. Das Kamerasystem 1 weist ein Objektiv 2 auf, das derart in einem Gehäuse 3 des Kamerasystems 10 angeordnet ist, dass Bildinformation von außerhalb des Kamerasystems 10 in das Innere des Gehäuses 3 geliefert werden kann.

Speziell liefert das Objektiv 2 Bildinformation von außerhalb des Kamerasystems an einen Bildsensor 4, der auf einer ersten Leiterplatte 5 angeordnet ist, die sich in dem Gehäuse 3 befindet und derart positioniert ist, dass der Bildsensor 4 dem Objektiv 2 direkt gegenüberliegt. Wie in Fig. 1 gezeigt, ist die erste Leiterplatte 5 über eine Verbindungseinheit 6 mit einer weiteren Leiterplatte 7 elektrisch verbunden. Wie in Fig. 1 gezeigt, ist speziell die Verbindungseinheit 6 der ersten Leiterplatte 5 an einem unteren Bereich der ersten Leiterplatte 5 auf einer Oberfläche angeordnet, die von dem Objektiv 2 abgewandt ist. Ferner ist eine Verbindungseinheit 6 an einem unteren Bereich der weiteren Leiterplatte 7 auf einer Oberfläche derart angeordnet, dass sie der Verbindungseinheit 6 der ersten Leiterplatte direkt gegenüberliegt, um so mit dieser elektrisch verbunden zu werden.

Wie in Fig. 1 gezeigt, weist somit sowohl die erste Leiterplatte 5 als auch die weitere Leiterplatte 7 eine Verbindungseinheit 6 auf, die derart angepasst sind, dass sie beispielsweise mittels Steckverbindung eine elektrische Verbindung zwischen der ersten Leiterplatte und der weiteren Leiterplatte 7 bereitstellen.

Die erste Leiterplatte 5 ist eine Sensorplatine, auf der der Bildsensor 4 angeordnet ist, wie oben erwähnt. Die weitere Leiterplatte 7 hat beispielsweise die Funktion zur Stromversorgung des Kamerasystems 10. Hierfür sind entsprechende elektronische Bauteile 8, wie in Fig. 1 gezeigt, auf der weiteren Leiterplatte 7 angeordnet, die die entsprechende Stromversorgungsfunktion für das Kamerasystem 10 bereitstellen.

Alternativ können auch auf der ersten Leiterplatte 5 entsprechende elektronische Bauteile 8 vorgesehen werden, die eine Stromversorgungsfunktion für das Kamerasystem 10 bereitstellen. In diesem Fall kann beispielsweise die weitere Leiterplatte 7 Bauteile 8 aufweisen, die die Funktion einer Signalumwandlung bereitstellen, um ein von dem Bildsensor 4 der ersten Leiterplatte 7 ausgegebenes Signal umzuwandeln und über einen elektrischen Anschluss 9, wie in Fig. 1 gezeigt, von dem Kamerasystem 10 nach außen zu liefern. Der elektrische Anschluss 9, wie in Fig. 1 gezeigt, kann beispielsweise auch verwendet werden zur Lieferung entsprechender Steuersignale an die elektronischen Bauteile 8 der weiteren Leiterplatte 7 oder an die elektronischen Bauteile 8 der ersten Leiterplatte 5.

Wie in Fig. 1 gezeigt ist die erste Leiterplatte 5 parallel zu der weiteren Leiterplatte 7 angeordnet, wobei sich die jeweiligen Verbindungseinheiten 6 der ersten Leiterplatte 5 und der weiteren Leiterplatte 7 im Wesentlichen senkrecht von einer Oberfläche der ersten Leiterplatte 5 bzw. der weiteren Leiterplatte 7 erstrecken. Speziell ist in einem Zustand, bei dem die erste Leiterplatte 5 und die weiter Leiterplatte 7 über die Verbindungseinheiten 6 elektrisch miteinander verbunden sind, eine Längsachse der Verbindungseinheiten 6 parallel zu einer Längsachse des Gehäuses 3 des Kamerasystems 10.

Wie oben beschrieben, sind bei dem Beispiel zur Erklärung der Erfindung genau zwei Leiterplatten (5, 7) vorgesehen, die über jeweilige Verbindungseinheiten (6) miteinander elektrisch verbunden sind. Beliebig viele weitere Leiterplatten können jedoch zwischen ihnen derart angeordnet werden, dass die Leiterplatten über ihre jeweiligen Verbindungseinheiten elektrisch miteinander verbunden sind, wie nachfolgend unter Bezugnahmen auf ein Ausführungsbeispiel der Erfindung beschrieben.

Fig. 2 zeigt eine schematische Querschnittsansicht eines Kamerasystems 20 gemäß einem Ausführungsbeispiel der vorliegenden Erfindung.

Zusätzlich zu dem Kamerasystem 10 gemäß dem ersten Ausführungsbeispiel weist das Kamerasystem 20 gemäß dem zweiten Ausführungsbeispiel weitere Leiterplatten 11 auf. Im Gegensatz zu der ersten Leiterplatte 5 und der weiteren Leiterplatte 7 gemäß dem ersten Ausführungsbeispiel haben die weiteren Leiterplatten 11 an ihrem unteren Bereich jeweils zwei Verbindungseinheiten 6, die sich auf gegenüberliegenden Oberflächen der weiteren Leiterplatte 11 entgegengesetzt weg erstrecken.

Wie in Fig. 2 gezeigt, erstreckt sich speziell die Verbindungseinheit 6a der weiteren Leiterplatte 11 von einer Oberfläche der Leiterplatte 11 weg in Richtung der ersten Leiterplatte 5 und dient zur Verbindung mit der Verbindungseinheit der ersten Leiterplatte 5.

Ferner ist eine zweite Verbindungseinheit 6b der weiteren Leiterplatte 11 derart ausgebildet, dass sie sich in entgegengesetzter Richtung von der Verbindungseinheit 6a von der weiteren Leiterplatte 11 weg erstreckt, um mit einer Verbindungseinheit einer weiteren Leiterplatte 11 verbunden zu werden.

Die in Fig. 2 gezeigten weiteren Leiterplatten 11 dienen zur Bereitstellung weiterer Funktionen bzw. Grundfunktionen für das Kamerasystem, beispielsweise zur Bereitstellung einer Bildverarbeitung, Funkübertragung, Bildübertragung, Signalübertragung, Heizungssteuerung, Messwertübertragung, Audioaufnahme etc.

Fig. 2 zeigt speziell vier Leiterplatten 5, 11 und 7 innerhalb des Kameragehäuses 3 des Kamerasystems 20, die derart angeordnet sind, dass sie sich parallel zueinander derart erstrecken, dass sie bezüglich der Längsrichtung des Gehäuses 3 hintereinander angeordnet sind. Speziell erstrecken sich die Leiterplatten 5, 7 und 11 im Wesentlichen senkrecht zu der Längsachse des Kameragehäuses 3.

Ähnlich wie die weitere Leiterplatte 7 gemäß dem ersten Ausführungsbeispiel enthalten auch die Leiterplatten 11 gemäß dem zweiten Ausführungsbeispiel elektrische Bauteile 8 zur Bereitstellung der entsprechender Funktionen bzw. Grundfunktionen zur Erweiterung des Funktionsumfangs des Kamerasystems 20 gemäß der Grundfunktion.

Wie in Fig. 2 gezeigt, erstrecken sich die jeweiligen Verbindungseinheiten 6, 6a, 6b der Leiterplatten 5, 7 und 11 entlang einer Achse, die im Wesentlichen parallel zu der Längsrichtung des Kameragehäuses 3 ist, bzw. parallel zu der Längsachse des Objektivs 2.

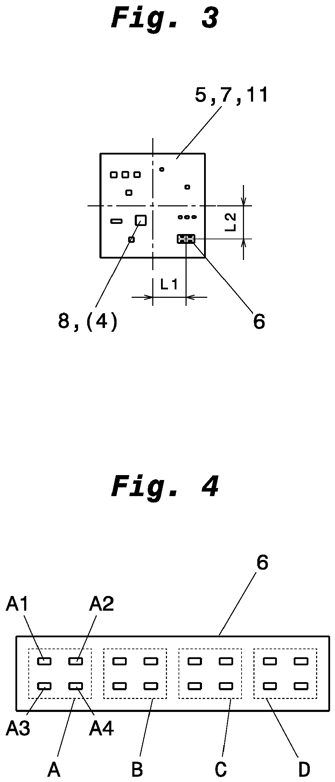

Speziell sind die jeweiligen Verbindungseinheiten der Leiterplatten 5, 7 und 11 an zu einander geometrisch kompatiblen vorbestimmten Positionen (L1, L2) auf mindestens einer Oberflächenseite einer Leiterplatte angeordnet, wie beispielsweise in Fig. 3 gezeigt.

Fig. 3 zeigt eine der Leiterplatten 5, 7, 11 gemäß dem Ausführungsbeispiel, wie oben beschrieben. Wie in Fig. 3 gezeigt, befindet sich die Verbindungseinheit 6 an einer vorbestimmten geometrischen Position (L1, L2), die für alle weiteren Leiterplatten 5, 7, 11 identisch ist.

Gemäß dem Ausführungsbeispiel, wie oben beschrieben, ist die Verbindungseinheit 6 auf nur einer Oberflächenseite der ersten Leiterplatte 5 (Sensorplatte), und der weiteren Leiterplatte 7 ausgebildet, wobei Verbindungseinheiten 6 (6a, 6b) der weiteren Leiterplatten 11, wie in Fig. 2 gezeigt, auch auf einer gegenüberliegenden Oberfläche (nicht in Fig. 3 gezeigt) an der Position (L1, L2) ausgebildet sind, um die entsprechenden Leiterplatten 5, 7 und 11 in einer modularen austauschbaren Art und Weise elektrisch miteinander zu verbinden.

Fig. 4 zeigt eine detailliertere Ansicht der Verbindungseinheit 6. Wie in Fig. 4 gezeigt, weist gemäß den vorliegenden Ausführungsbeispielen die Verbindungseinheit 6 vier Gruppen von elektrischen Anschlüssen A, B, C, D auf, die wiederum jeweils elektrische Anschlüsse A1, A2, A3, A4 enthalten.

Gemäß dem vorliegenden Ausführungsbeispiel dienen die Gruppen von elektrischen Anschlüssen A, B, C zur Verbindung von Leiterplatten, die eine kamerasystemspezifische Grundfunktion bereitstellen, wie beispielsweise Bildaufnahme, Signalwandlung, Funkübertragung, Stromversorgung, Bildverarbeitung, Bildübertragung, Signalübertragung, Messwertübergabe, Audioaufnahme, etc. Die in Fig. 4 gezeigte Gruppe von elektrischen Anschlüssen D der Verbindungseinheit 6 dient beispielsweise zur Bereitstellung einer Zusatzfunktion, wie beispielsweise Heizungssteuerung.

Wie in Fig. 4 gezeigt, sind gemäß dem bevorzugten Ausführungsbeispiel die Gruppen von elektrischen Anschlüssen A, B, C, D in einer Reihe hintereinander bzw. nebeneinander angeordnet. Alternativ ist es auch möglich, die Gruppen von elektrischen Anschlüssen A, B, C, D in einer beliebigen geometrischen Anordnung vorzusehen, sofern diese spezielle geometrische Anordnung bei allen weiteren Leiterplatten, die modular austauschbar in das Kamerasystem eingebaut werden sollen, identisch ist.

Wie in Fig. 4 gezeigt, weist die Gruppe von elektrischen Anschlüssen A vier an vorbestimmten geometrischen Orten angeordnete elektrische Anschlüsse A1, A2, A3 und A4 auf, die beispielsweise für eine Grundfunktion benötigt werden, zum Beispiel Masse, Versorgungsspannung, etc. Andere geometrische Anordnungen der elektrischen Anschlüsse A1, A2, A3, A4 und deren Anzahl sind gemäß der Erfindung denkbar.

Das im vorangegangenen beschriebene Kamerasystem gemäß der Erfindung kann alleinstehend oder beispielsweise in einem Fahrzeug oder beispielsweise in einem Spiegelersatzsystem für Fahrzeuge, beispielsweise Nutzfahrzeuge eingesetzt werden.

Es wird explizit betont, dass alle in der Beschreibung und/oder den Ansprüchen offenbarten Merkmale als getrennt und unabhängig voneinander zum Zweck der ursprünglichen Offenbarung ebenso wie zum Zweck des Einschränkens der beanspruchten Erfindung unabhängig von den Merkmalskombinationen in den Ausführungsformen und/oder den Ansprüchen angesehen werden sollen. Es wird explizit festgehalten, dass alle Bereichsangaben oder Angaben von Gruppen von Einheiten jeden möglichen Zwischenwert oder Untergruppe von Einheiten zum Zweck der ursprünglichen Offenbarung ebenso wie zum Zweck des Einschränkens der beanspruchten Erfindung offenbaren, insbesondere auch als Grenze einer Bereichsangabe.

### Bezugszeichenliste

- 10: Kamerasystem
- 2: Objektiv
- 3: Gehäuse
- 4: Bildsensor
- 5: erste Leiterplatte
- 6: Verbindungseinheit
- 7: weitere Leiterplatte
- 8: elektrisches Bauteil
- 9: elektrischer Anschluss
- 20: Kamerasystem
- 11: weitere Leiterplatte
- 6a, 6b: Verbindungseinheiten
- A, B, C, D: Gruppen von elektrischen Anschlüssen
- A1-A4: elektrische Anschlüsse

## Patentansprüche

1. Kamerasystem für ein Fahrzeug, mit
einem Objektiv (2);
einer ersten Leiterplatte (5), die mit einem Bildsensor (4) versehen ist zum Erfassen einer über das Objektiv (2) erhaltenen Bildinformation; und
einer weiteren Leiterplatte (7), die für die Kamera eine vorbestimmte Funktion bereitstellt; wobei
zwischen der ersten Leiterplatte (5) und der weiteren Leiterplatte (7) mindestens eine andere weitere Leiterplatte (11), die für das Kamerasystem (10, 20) eine vorbestimmte kameraspezifische Grundfunktion bereitstellt, anordbar ist, und
jede der Leiterplatten (5, 7, 11) mindestens eine Verbindungseinheit (6) derart aufweist, dass die erste Leiterplatte (5) elektrisch mit der weiteren Leiterplatte (7) und einer der anderen weiteren Leiterplatten (11) verbindbar ist, und jede der anderen weiteren Leiterplatten (11) elektrisch modular miteinander austauschbar verbindbar ist zur Anpassung des Funktionsumfangs des Kamerasystems (10, 20) gemäß der vorbestimmten kameraspezifischen Grundfunktion und mit der weiteren Leiterplatte (7) elektrisch verbindbar ist, wobei jede der Verbindungseinheiten (6) eine Mehrzahl von Gruppen von elektrischen Anschlüssen (A, B, C, D) aufweist, über die die erste Leiterplatte (5) mit der weiteren Leiterplatte (7) und der mindestens einen anderen weiteren Leiterplatte (11) verbindbar ist zur Bereitstellung der vorbestimmten kameraspezifischen Grundfunktion für das Kamerasystem (10, 20), wobei eine jeweilige Gruppe von elektrischen Anschlüssen (A, B, C, D) eine Mehrzahl von elektrischen Anschlüssen (A1, A2, A3, A4) aufweist, die erforderlich sind für eine Grundfunktion zum Betreiben von jeder der mindestens einen anderen weiteren Leiterplatte (11), zur Bereitstellung der vorbestimmten kameraspezifischen Grundfunktion.

2. Kamerasystem nach Anspruch 1, bei dem die jeweiligen Verbindungseinheiten (6) der ersten Leiterplatte (5) und der mindestens einen weiteren Leiterplatte (7, 11) an zueinander geometrisch kompatiblen vorbestimmten Position (L1, L2) auf mindestens einer Oberflächenseite der ersten Leiterplatte (5) und der mindestens einen weiteren Leiterplatte (7, 11) angeordnet sind.

3. Kamerasystem nach Anspruch 1, bei dem die Leiterplatten (5, 7, 11) über die Mehrzahl von elektrischen Anschlüssen (A1, A2, A3, A4) miteinander verbindbar sind.

4. Kamerasystem nach einem der vorangegangenen Ansprüche, bei dem mehrere Verbindungseinheiten (6) pro Leiterplatte vorgesehen sind.

5. Kamerasystem nach einem der vorangegangenen Ansprüche, bei dem die mindestens eine weitere Leiterplatte (7, 11) einen elektrischen Anschluss (9) aufweist zur Übertragung von Daten und/oder eines Signals aus dem Kamerasystem heraus nach außen.

6. Kamerasystem nach einem der vorangegangenen Ansprüche, bei dem die mindestens eine weitere Leiterplatte (7, 11) auf einer Seite der ersten Leiterplatte (5) angeordnet ist, die dem Objektiv (2) abgewandt ist.

7. Kamerasystem nach Anspruch 8, bei dem mehrere weitere Leiterplatten (7, 11) in Bezug auf die erste Leiterplatte (5) hintereinander angeordnet sind.

8. Kamerasystem nach einem der vorangegangenen Ansprüche, bei dem die mindestens eine weitere Leiterplatte (7, 11) mindestens einen elektronischen Baustein (8) aufweist, der angepasst ist zum Bereitstellen der vorbestimmten kameraspezifischen Grundfunktion zur Erweiterung des Kamerasystems (10, 20).

9. Kamerasystem nach einem der vorangegangenen Ansprüche, bei dem die vorbestimmte kameraspezifische Grundfunktion zur Erweiterung des Kamerasystems (10, 20) wenigstens eine ist von Signalaufnahme, Signalverarbeitung, Signalübertragung, Stromversorgung und Steuerfunktion.

10. Kamerasystem nach einem der vorangegangenen Ansprüchen, bei dem die wenigstens eine Verbindungseinheit (6) der Leiterplatten (5, 7, 11) als Steckverbindungen ausgebildet ist zur elektrischen Verbindung der Leiterplatten (5, 7, 11) miteinander über die elektrischen Anschlüsse (A1, A2, A3, A4) der Gruppen von elektrischen Anschlüssen (A, B, C, D).

## Claims

1. A camera system for a vehicle, comprising
an objective lens (2);
a first printed circuit board (5) provided with an image sensor (4) for acquiring image information obtained via the objective lens (2); and
an additional printed circuit board (7) adapted for providing a predetermined function, wherein
at least one further additional printed circuit board (11) is provideable between the first printed circuit board (5) and the additional printed circuit board (7) for providing a predetermined camera specific basic function, and
each of the printed circuit boards (5, 7, 11) comprises at least a connection unit (6) such that the first printed circuit board (5) is electrically connectable to the additional printed circuit board (7) and one of the further additional printed circuit boards (11), and wherein each of the further additional printed circuit boards (11) is electrically connectable to each other in a modular exchangeable manner for adapting the range of functions of the camera system (10, 20) according to the predetermined camera specific basic function and electrically connectable with the additional printed circuit board (7), wherein each of the connection units (6) comprises a plurality of groups of electrical connection (A, B, C, D) via the first printed circuit board (5) is connectable to the additional printed circuit board (7) and to the at least one further additional printed circuit board (11) for providing the predetermined camera specific basic function for the camera system (10, 20), wherein a respective group of electrical connections (A, B, C, D) comprises a plurality of electrical terminals (A1, A2, A3, A4) necessary for a basic function for operating each of the at least one further additional printed circuit board (11) for providing the predetermined camera specific basic function.

2. The camera system according to claim 1, wherein the respective connection units (6) of the first printed circuit board (5) and the at least one additional printed circuit board (7, 11) are arranged at predetermined positions (L1, L2) geometrically compatible to each other on at least a surface side of the first printed circuit board (5) and the at least one additional printed circuit board (7, 11).

3. The camera system according to claim 1, wherein the printed circuit boards (5, 7, 11) are connectable to each other via the plurality of electrical terminals (A1, A2, A3, A4).

4. The camera system according to any one of the preceding claims, wherein plural connection units (6) are provided for each printed circuit board.

5. The camera system according to any one of the preceding claims, wherein the at least one additional printed circuit board (7, 11) comprises an electrical connection (9) for transmitting data and/or a signal to the exterior of the camera system.

6. The camera system according to any one of the preceding claims, wherein the at least one additional printed circuit board (7, 11) is arranged on a side of the first printed circuit board (5), which is opposite to the side of the objective lens (2).

7. The camera system according to claim 8, wherein plural printed circuit boards (7, 11) are arranged one after another with respect to the first printed circuit board (5).

8. The camera system according any one of the preceding claims, wherein the at least one additional printed circuit board (7, 11) comprises at least one electrical component (8) adapted for providing the predetermined camera specific basic function for expanding the camera system (10, 20).

9. The camera system according to any one of the preceding claims, wherein the predetermined camera specific basic function for expanding the camera system (10, 20) is at least one of signal acquisition, signal processing, signal transmission, power supply and control function.

10. The camera system according to any one of the preceding claims, wherein the at least one connection unit (6) of the printed circuit boards (5, 7, 11) is a plug connection for electrically connecting the printed circuit boards (5, 7, 11) to each other via the electrical terminals (A1, A2, A3, A4) of the groups of electrical connections (A, B, C, D).

## Revendications

1. Système de caméra pour un véhicule avec
un objectif (2) ;
une première carte de circuits imprimés (5), qui est pourvue d'un capteur d'image (4) pour la détection d'une information d'image reçue par le biais de l'objectif (2) ; et
une autre carte de circuits imprimés (7) qui met à disposition de la caméra une fonction prédéterminée ; dans lequel
au moins une autre carte de circuits imprimés supplémentaire (11) qui met à disposition du système de caméra (10, 20) une fonction de base spécifique à la caméra prédéterminée, peut être agencée entre la première carte de circuits imprimés (5) et l'autre carte de circuits imprimés (7), et
chacune des cartes de circuits imprimés (5, 7, 11) présente au moins une unité de connexion (6) de telle manière que la première carte de circuits imprimés (5) puisse être connectée électriquement à l'autre carte de circuits imprimés (7) et à l'une des autres cartes de circuits imprimés supplémentaires (11), et chacune des autres cartes de circuits imprimés supplémentaires (11) peut être connectée électriquement de manière interchangeable l'une avec l'autre par voie modulaire pour l'adaptation de la périphérie fonctionnelle du système de caméra (10, 20) selon la fonction de base spécifique à la caméra prédéterminée, et peut être connectée électriquement à l'autre carte de circuits imprimés (7), dans lequel chacune des unités de connexion (6) présente une pluralité de groupes de bornes électriques (A, B, C, D) par lesquelles la première carte de circuits imprimés (5) peut être connectée à l'autre carte de circuits imprimés (7) et à l'au moins une autre carte de circuits imprimés (11) pour la mise à disposition de la fonction de base spécifique à la caméra prédéterminée pour le système de caméra (10, 20), dans lequel un groupe respectif de bornes électriques (A, B, C, D) présente une pluralité de bornes électriques (A1, A2, A3, A4) qui sont nécessaires pour une fonction de base pour le fonctionnement de chacune des au moins une autre carte de circuits imprimés supplémentaire (11), pour la mise à disposition de la fonction de base spécifique à la caméra prédéterminée.

2. Système de caméra selon la revendication 1, dans lequel les unités de connexion (6) respectives de la première carte de circuits imprimés (5) et de l'au moins une autre carte de circuits imprimés (7, 11) sont agencées dans une position (L1, L2) prédéterminée compatible géométriquement l'une à l'autre sur au moins un côté de surface de la première carte de circuits imprimés (5) et l'au moins une autre carte de circuits imprimés (7, 11).

3. Système de caméra selon la revendication 1, dans lequel les cartes de circuits imprimés (5, 7, 11) peuvent être connectées par la pluralité de bornes électriques (A1, A2, A3, A4) les unes aux autres.

4. Système de caméra selon l'une quelconque des revendications précédentes, dans lequel plusieurs unités de connexion (6) sont prévues par carte de circuits imprimés.

5. Système de caméra selon l'une quelconque des revendications précédentes, dans lequel l'au moins une autre carte de circuits imprimés (7, 11) présente une borne électrique (9) pour la transmission de données et/ou d'un signal du système de caméra vers l'extérieur.

6. Système de caméra selon l'une quelconque des revendications précédentes, dans lequel l'au moins une autre carte de circuits imprimés (7, 11) est agencée sur un côté de la première carte de circuits imprimés (5) qui est opposée à l'objectif (2).

7. Système de caméra selon la revendication 8, dans lequel plusieurs autres cartes de circuits imprimés (7, 11) sont agencées les unes derrière les autres par rapport à la première carte de circuits imprimés (5).

8. Système de caméra selon l'une quelconque des revendications précédentes, dans lequel l'au moins une autre carte de circuits imprimés (7, 11) présente au moins un composant électrique (8) qui est adapté pour la mise à disposition de la fonction de base spécifique à la caméra prédéterminée pour l'élargissement du système de caméra (10, 20).

9. Système de caméra selon l'une quelconque des revendications précédentes, dans lequel la fonction de base spécifique à la caméra prédéterminée pour l'élargissement du système de caméra (10, 20) est au moins l'un(e) parmi la réception de signal, le traitement de signal, la transmission de signal, l'alimentation électrique et la fonction de commande.

10. Système de caméra selon l'une quelconque des revendications précédentes, dans lequel l'au moins une unité de connexion (6) des cartes de circuits imprimés (5, 7, 11) se présente sous la forme de prises pour la connexion électrique des cartes de circuits imprimés (5, 7, 11) entre elles par le biais des bornes électriques (A1, A2, A3, A4) des groupes de bornes électriques (A, B, C, D).
